# EUROPEAN PATENT SPECIFICATION

(11) **EP 3 299 162 B1**
(45) Date of publication and mention of the grant of the patent: **02.09.2020**
(21) Application number: 17190350.3
(22) Date of filing: 11.09.2017
(51) Int. Cl.: B32B 7/06, B32B 27/08, B32B 27/18, B32B 27/30, B32B 7/12, B32B 27/28, B32B 27/34, B32B 27/36, B32B 27/40

(54) **WINDOW FOR DISPLAY DEVICE AND DISPLAY DEVICE**
FENSTER FÜR EINE ANZEIGEVORRICHTUNG UND ANZEIGEVORRICHTUNG
FENÊTRE POUR DISPOSITIF D'AFFICHAGE ET DISPOSITIF D'AFFICHAGE

(30) Priority: 27.09.2016 KR 20160124090
(43) Date of publication of application: 28.03.2018
(73) Proprietor: Samsung Electronics Co., Ltd., Gyeonggi-do 16677 (KR)
(72) Inventor: PARK, Byung Ha, Yongin-si Gyeonggi-do (KR); KWON, Myong Jong, Gyeonggi-do (KR); KIM, Nak Hyun, Gyeonggi-do (KR); SEO, Seoung Jin, Gyeonggi-do (KR); CHUNG, Hyunwoong, Gyeonggi-do (KR); HAM, Cheol, Gyeonggi-do (KR); HONG, Sung Hun, Gyeonggi-do (KR)
(74) Representative: Elkington and Fife LLP

(56) References cited:
- US-A1- 2014 295 157
- US-B2- 9 259 898

## Description

### FIELD OF THE INVENTION

A window for a display device and a display device are disclosed.

### BACKGROUND OF THE INVENTION

As a portable electronic device such as a smart phone or a tablet PC is becoming more diversified, there is also a need for a display device which has a bendable or foldable flexibility as well as to being slim and light-weight.

In general, the display device mounted in the portable electronic device may include a rigid glass for protecting a display module. However, the glass lacks the desired amount of flexibility to be effectively used for a flexible display device. The use of a polymer film has been investigated as an alternative for the glass, however, the polymer film may not have sufficient impact resistance, and may not effectively protect the display module.

Therefore, there is a need for a window for a display which is capable of providing both the desired flexibility and impact resistance.

US 9,259,898 discloses a transparent laminate including a transparent material layer, a transparent high-elasticity layer laminated on both sides of the transparent material layer and having Young's modulus of less than or equal to about 10 MPa. US 2014/0295157 discloses a window for a display device which includes a first resin layer including silsesquioxane, and a second resin layer disposed on one side of the first resin layer and including a polymer having a coefficient of thermal expansion of ± 20 ppm/°C relative to the coefficient of thermal expansion of the silsesquioxane.

### SUMMARY OF THE INVENTION

An embodiment provides a flexible window for a display device having improved impact resistance.

Another embodiment provides a display device including the flexible window for a display device.

According to an embodiment, a window for a display device includes a polymer substrate, a first buffer layer under the polymer substrate and comprising polyurethane, a silicone resin, or a combination thereof, a first transparent adhesion layer between the polymer substrate and the first buffer layer, and a protective layer on the polymer substrate.

The first buffer layer may have a thickness of about 150 micrometers (µm) to about 250 µm.

The window for a display device may have a stiffness of less than or equal to about 10 Newtons (N) when the window for the display device is folded at a curvature radius of about 1 millimeter (mm).

The first buffer layer includes polyurethane, poly(meth)acrylate, a silicone resin, or a combination thereof.

The first buffer layer may have a substantially uniform thickness throughout the buffer layer.

The polymer substrate may include polyimide, polyamide, polyethylene terephthalate, polyethylene naphthalate, polymethylmethacrylate, polycarbonate, a copolymer thereof, or a combination thereof.

The polymer substrate may have a thickness of about 25 µm to about 100 µm.

The first transparent adhesion layer may have a thickness of about 5 µm to about 200 µm and an elastic modulus of less than or equal to about 0.1 MPa.

The protective layer may include a (meth)acryl resin, an epoxy resin, silicone resin, an oxetane resin, a urethane resin, a urethane (meth)acrylate resin, an inorganic particle, polysilsesquioxane, or a combination thereof.

The protective layer may have a thickness of about 1 µm to about 50 µm.

The window for a display device may further include a second buffer layer between the polymer substrate and the protective layer.

The second buffer layer may have an elastic modulus of about 7 MPa to about 30 MPa.

The window for a display device may further include a second transparent adhesion layer between the polymer substrate and the second buffer layer.

According to another embodiment, a display device includes a display panel and including the window for a display device, wherein the window for the display device includes, a polymer substrate, a first buffer layer under the polymer substrate and having an elastic modulus of about 7 megapascals to about 30 megapascals, a first transparent adhesion layer between the polymer substrate and the first buffer layer, and a protective layer on the polymer substrate.

The display panel may be an organic light emitting display panel or a liquid crystal display panel.

The display panel may be a bendable display panel, a foldable display panel or a rollable display panel.

The display device may further include a touch panel between the display panel and the window for the display device.

The highest height which may not generate a bright spot on the display panel may be greater than or equal to about 9 centimeters (cm) as measured by dropping a 30 g pendulum on a top part of the window using a Dupont Impact Tester.

The highest height which may not generate a bright spot on the display panel may be about 9 cm to about 12 cm, when dropping a 30 g pendulum on the window using a Dupont Impact Tester.

By providing a window for a display device simultaneously satisfying the desired flexibility and impact resistance properties, the window may be effectively applied to a bendable, foldable, or rollable display device.

### BRIEF DESCRIPTION OF THE DRAWINGS

FIG. 1 is a cross-sectional view of a window for a display device, according to an embodiment,
FIG. 2 is a cross-sectional view of a window for a display device, according to another embodiment,
FIG. 3 is a cross-sectional view of a window for a display device, according to yet another embodiment,
FIG. 4 is a cross-sectional view of a display device, according to an embodiment,
FIG. 5 is a cross-sectional view of a display device, according to another embodiment, and
FIGS. 6 to 10 are schematic views showing a bendable or foldable form of a window for a display device, according to one embodiment.

### DETAILED DESCRIPTION OF THE EMBODIMENTS

Exemplary embodiments will hereinafter be described in detail with reference to the accompanying drawings, in which various embodiments are shown. However, this disclosure may be embodied in many different forms and is not to be construed as limited to the exemplary embodiments set forth herein.

In the drawings, the thickness of layers, films, panels, regions, etc., are exaggerated for clarity. Like reference numerals designate like elements throughout the specification. It will be understood that when an element such as a layer, film, region, or substrate is referred to as being "on" another element, it can be directly on the other element or intervening elements may also be present. In contrast, when an element is referred to as being "directly on" another element, there are no intervening elements present.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, the singular forms "a," "an," and "the" are intended to include the plural forms, including "at least one," unless the content clearly indicates otherwise. "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Spatially relative terms, such as "beneath," "under," "below," "lower," "above," "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10%, 5% of the stated value.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

As used herein, the term 'combination' refers to a mixture of two or more materials and/or a laminate of two or more layers.

Hereinafter, a window for a display device according to an embodiment is described.

As used herein, the term "(meth)acryl" includes any group containing the moiety H₂C=CHRC(=O)- wherein R is hydrogen ("acryl" herein) or methyl ("methacryl" herein). "(Meth)acryl" includes the corresponding acids or salts thereof (referred to herein as "(meth)acrylic"), esters (referred to herein as "(C₁-C₂₀ alkyl) (meth)acrylate"), and amides (referred to herein as "(meth)acrylamide").

Herein, "(meth)acryl polymer" or "(meth)acryl resin" includes any polymer derived from polymerization of an acryl or a methacryl monomer, e.g., acrylonitrile, methacrylonitrile, acrylamide, methacrylamide, acrylic acid, methacrylic acid, or an ester of acrylic or methacrylic acid.

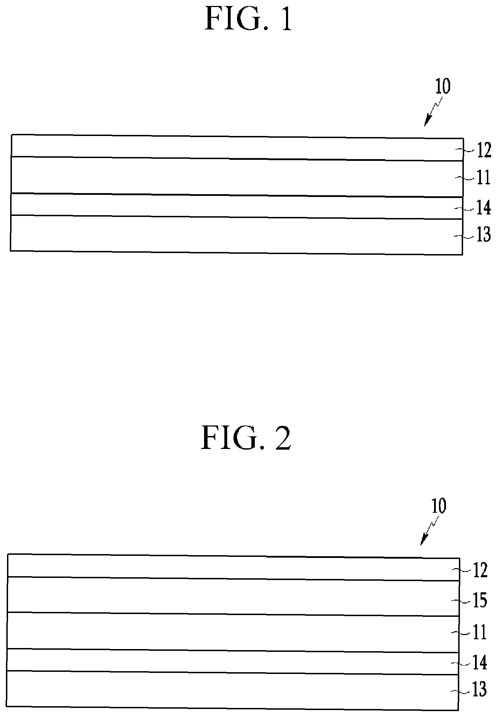

FIG. 1 is a cross-sectional view of a window 10 for a display device, according to an embodiment.

Referring to FIG. 1, the window 10 for a display device according to one embodiment, includes a substrate 11, a protective layer 12 disposed on the substrate 11, a first buffer layer 13 disposed under the substrate 11, and a first transparent adhesion layer 14 disposed between the substrate 11 and the first buffer layer 13 and binding (i.e., adhering) the two layers together.

The substrate 11 may be a polymer substrate, for example a transparent polymer substrate. The polymer substrate may include, for example polyimide, polyamide, polyethylene terephthalate, polyethylene naphthalate, polymethylmethacrylate, polycarbonate, a copolymer thereof, or a combination thereof, but is not limited thereto.

The substrate 11 may have, for example, a light transmittance of greater than or equal to about 85 percent (%), or greater than or equal to about 90%, or greater than or equal to about 95%, and a yellowness index (YI) of less than or equal to about 3.0, or less than or equal to about 2.0, or less than or equal to about 1.5.

The substrate 11 may have, for example a thickness of about 10 µm to about 150 µm, or about 20 µm to about 125 µm, or about 25 µm to about 100 µm, or about 25 µm to about 75 µm

The protective layer 12 may be disposed on the substrate 11 to protect the window 10 from mechanical and/or physical damage. The protective layer 12 may be, for example, a hard coating layer, a scratch resistant layer, or a layer formed of a material having high hardness.

The protective layer 12 may include a material having high hardness characteristics, and may be, for example, an organic material, an inorganic material, an organic/inorganic hybrid material, or a combination thereof. The protective layer 12 may include, for example, an organic material such as a (meth)acryl resin, an epoxy resin, a silicone resin, an oxetane resin, a urethane resin, a urethane (meth)acrylate resin, or a combination thereof; an inorganic material such as silica, alumina, or zirconia; an organic/inorganic hybrid material such as polysilsesquioxane; or a mixture of the inorganic material and/or the organic/inorganic hybrid material with the organic material; or a combination thereof. The protective layer 12 may include, for example, a mixture of an inorganic material, such as silica, alumina, or zirconia, and/or an organic/inorganic hybrid material such as polysilsesquioxane, with an organic material such as a (meth)acryl resin, an epoxy resin, a silicone resin, an oxetane resin, a urethane resin, a urethane (meth)acrylate resin, or a combination thereof. Herein, the inorganic material and/or the organic/inorganic material may be surface-modified. The surface modification may include, for example, a functional group bound or grafted onto a surface of the inorganic material and/or the organic/inorganic material.

The protective layer 12 may have, for example, a pencil hardness of greater than or equal to about 2H, for example, greater than or equal to about 3H, for example, greater than or equal to about 4H, or may have a pencil hardness within the range. The pencil hardness may be measured according to ASTM D3363 using a load of 1 kilogram (kg).

The protective layer 12 may have a thickness of about 1 µm to about 50 µm, or about 5 µm to about 50 µm, or about 10 µm to about 40 µm.

The protective layer 12 may be disposed on a single surface of the substrate 11. In one embodiment, the protective layer 12 may be disposed only on the substrate 11 and only on an upper surface of the substrate 11, and may be not disposed under the substrate 11. Thereby, the window 10 may have enhanced flexibility as compared to a window including a protective layer 12 on both the upper and lower surfaces of the substrate 11.

The first buffer layer 13 is disposed under the substrate 11 and faces toward the protective layer 12 in a center of the substrate 11. The first buffer layer 13 may be disposed under the substrate 11 to absorb and/or smooth an impact force to an upper side of the substrate 11, and which is transmitted to the lower side of the substrate 11. Thus when the window 10 is disposed on a display panel, such as for example, a liquid crystal display panel or an organic light emitting display panel, an impact force applied to the window 10 is reduced or is prevented from being transmitted toward the display panel side so as to effectively protect the display device.

The first buffer layer 13 may have an elastic modulus of about 7 MPa to about 30 MPa, or about 5 MPa to about 25 MPa, or about 10 MPa to about 20 MPa. By having the elastic modulus within these ranges, the first buffer layer 13 may effectively absorb and/or smooth an external impact force. In an exemplary embodiment, the first buffer layer 13 may have an elastic modulus of, for example, about 10 MPa to about 20 MPa.

The first buffer layer 13 includes polyurethane, poly(meth)acrylate, a silicone resin, or a combination thereof satisfying the modulus.

The first buffer layer 13 may have a uniform thickness or a substantially uniform thickness throughout the entire first buffer layer 13. As used herein, "substantially uniform thickness" refers to a layer having a thickness which varies by less than about 1 percent, or less than about 0.5 percent, or less than about 0.1 percent. The thickness of the first buffer layer 13 may be about 100 µm to about 300 µm, or about 125 µm to about 275 µm, or about 150 µm to about 250 µm. By having the substantially uniform thickness throughout the entire first buffer layer 13, the window 10 may be folded, bent, or rolled regardless of the direction and/or the position in which the folding, bending, or rolling occurs. In addition, as the first buffer layer 13 has the thickness within the range, the folding, the bending and/or the rolling the window 10 may be effectively accomplished while effectively absorbing and/or smoothing any external impact.

The substrate 11 and the first buffer layer 13 may be bound (i.e., adhered) to one another by a first transparent adhesion layer 14. The first transparent adhesion layer 14 may include an adhesive, and may include, for example, an optically clear adhesive (OCA).

The first transparent adhesion layer 14 may secondarily absorb and/or smooth an impact force transmitted to the lower part of the substrate 11, as well as bind the substrate 11 and the first buffer layer 13. Thereby, the first transparent adhesion layer 14 may effectively absorb and/or smooth an impact force which may be transmitted to the lower part of the substrate 11, together with the first buffer layer 13.

The first transparent adhesion layer 14 may have, for example, an elastic modulus of less than or equal to about 0.1 MPa, or less than or equal to about 0.05 MPa, or less than or equal to about 0.01 MPa. The first transparent adhesion layer 14 may have a modulus of, for example, about 0.001 MPa to about 0.1 MPa, or about 0.005 MPa to about 0.1 MPa, or for example, a modulus of about 0.01 MPa to about 0.1 MPa.

The first transparent adhesion layer 14 may have, for example a thickness of about 5 µm to about 200 µm. The first transparent adhesion layer may have, for example, a thickness of about 5 µm to about 150 µm, a thickness of about 10 µm to about 120 µm, a thickness of about 15 µm to about 100 µm, or a thickness of about 20 µm to about 80 µm.

When the window 10 is bent or folded at a predetermined curvature radius, it may have a stiffness which is less than or equal to a predetermined range, so that the folding and/or the bending the window 10 may be effectively accomplished. For example, the window 10 may have a stiffness of less than or equal to about 10 N when folded at a curvature radius of about 1 mm. Within the range, the window 10 may have a stiffness of, for example, less than or equal to about 9 N, for example, less than or equal to about 8 N, for example, less than or equal to about 7 N.

As the window 10 includes a protective layer 12 on one surface of the substrate 11 and a first buffer layer 13 on the opposite surface of the substrate 11, the window may effectively absorb and/or smooth any external impact while also having scratch resistance and high hardness characteristics. As a result, the window is capable of effectively protecting a display panel and ensuring the flexibility thereof. The window may have good impact resistance and hardness. The Dupont Impact Tester may be used to evaluate the impact resistance of the display device by dropping a pendulum having a predetermined weight (e.g., about 30 grams) from a predetermined height (e.g., about 0.5 cm to about 100 cm) onto the surface of the window 10, and determining the highest height which does not damage or deform the window 10 or the display panel when impacted by the pendulum. For example, an impact resistance of greater than or equal to about 6 cm means that no damage or deformation of the window or the display panel occurred when a pendulum having a weight of about 30 grams was dropped from a height of about 6 cm or less.

The pencil hardness of the window may be measured in accordance with ASTM D3363 using a load of 1 kilogram (kg).

For example, the window 10 may have a pencil hardness of greater than or equal to about 3H and may also have an impact resistance of greater than or equal to about 6 cm, when the impact resistance is measured by a Dupont Impact Tester using a 30 g pendulum.

For example, the window 10 may have a pencil hardness of greater than or equal to about 3H and may also have an impact resistance of greater than or equal to about 8 cm, when the impact resistance is measured by a Dupont Impact Tester using a 30 g pendulum.

For example, the window 10 may have a pencil hardness of greater than or equal to about 3H and may also have an impact resistance of greater than or equal to about 9 cm, when the impact resistance is examined by a Dupont Impact Tester using a 30 g pendulum.

For example, the window 10 may have a pencil hardness of greater than or equal to about 3H and may also have an impact resistance of about 8 cm to about 15 cm, or about 9 cm to about 12 cm when the impact resistance is examined by a Dupont Impact Tester using a 30 g pendulum.

For example, the window 10 may have a pencil hardness of greater than or equal to about 3H and may also have an impact resistance of greater than or equal to about 10 cm, when the impact resistance is examined by a Dupont Impact Tester using a 30 g pendulum.

For example, the window 10 may have a pencil hardness of greater than or equal to about 3H and may also have an impact resistance of about 10 cm to about 12 cm, when the impact resistance is examined by a Dupont Impact Tester using a 30 g pendulum.

In addition, the window 10 includes a protective layer 12 on a single surface of the substrate 11 assembled with the first transparent adhesion layer 14 and the first buffer layer 13, so the support provided by the protective layer 12 may be intensified. Accordingly, when the protective layer 12 is disposed on only one surface of the substrate 11, it may minimize the phenomenon in which terminal ends of the structure are curled, and so the processability and the productivity may be improved.

In addition, the window 10 may have a high flexibility.

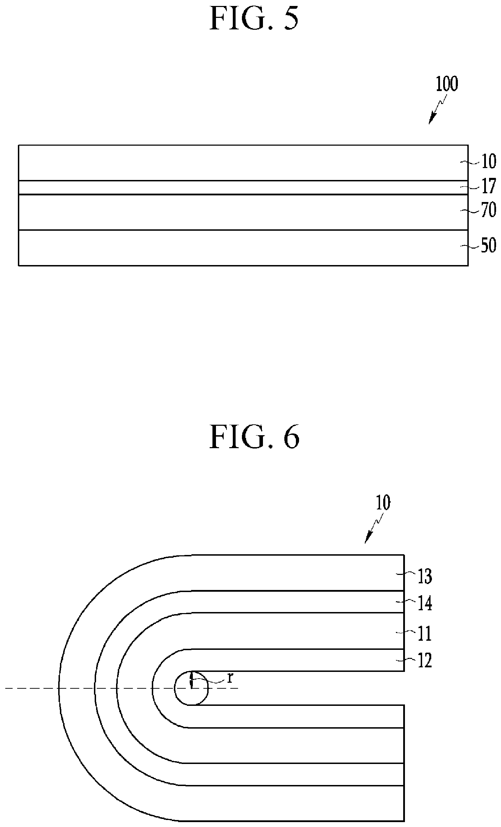

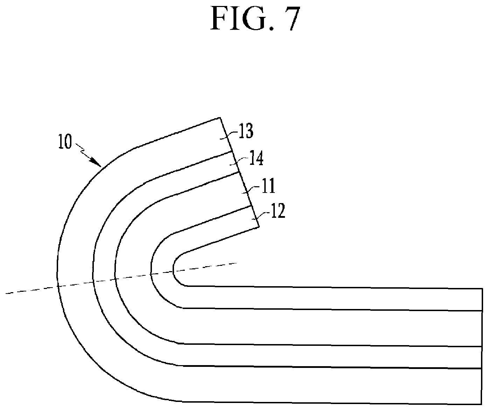

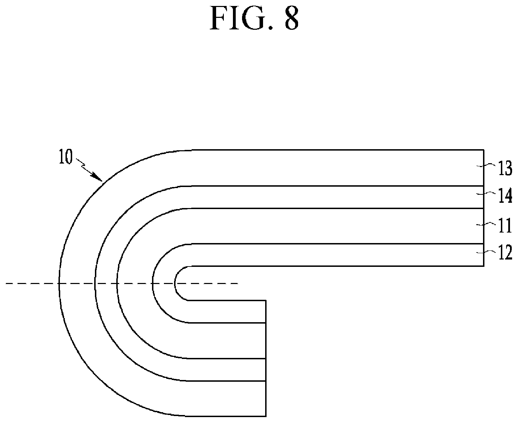

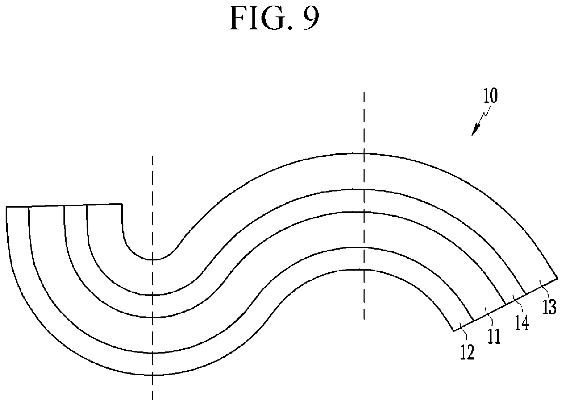

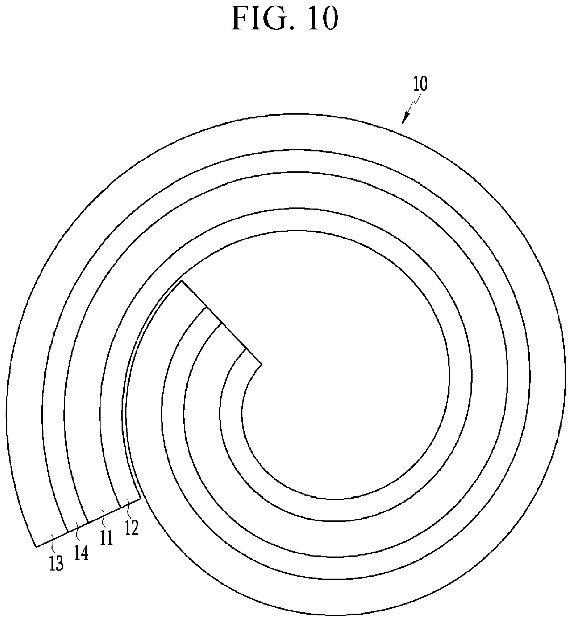

FIGS. 6 to 10 are schematic views showing bending, folding, or rolling forms of a window for a display device according to one embodiment.

Referring to FIGS. 6 to 10, the window 10 for a display device according to one embodiment may be bent, folded, or rolled in a variety of shapes, and is bendable, foldable, or rollable at any points of the window 10.

The window 10 for a display device may be bent, folded, or rolled to provide, for example, a curvature radius (r) of less than or equal to about 5 mm, for example, a curvature radius (r) of less than or equal to about 3 mm, for example, a curvature radius (r) of less than or equal to about 2 mm, for example, a curvature radius (r) of less than or equal to about 1 mm.

Like this, the window 10 for a display device simultaneously satisfies the desired impact resistance and flexibility, so as to be effectively applied to a bendable, foldable, or rollable display device.

FIG. 2 is a cross-sectional view of a window for a display device according to another embodiment.

As shown in FIG. 2, the window 10 for a display device according to the present embodiment includes a substrate 11, a protective layer 12 disposed on the substrate 11, a first buffer layer 13 disposed under the substrate 11, and a first transparent adhesion layer 14 disposed between the substrate 11 and the first buffer layer 13, alike the above embodiment (i.e., FIG. 1).

However, the window 10 for a display device according to this embodiment further includes a second buffer layer 15 disposed on the substrate 11, which differs from the above embodiment.

The second buffer layer 15 absorbs and/or smooths any impact which may be transmitted to the top surface of the substrate 11 and/or the bottom surface of the substrate 11, so that the second buffer layer 15 may further enhance the impact resistance of the window 10, together with the first buffer layer 13. When the window 10 is disposed on the display panel, such as a liquid crystal display panel or an organic light emitting display panel, the transmission of an impact applied to the window 10 side toward the display panel side may be reduced and prevented, so that the display device may be effectively protected.

The second buffer layer 15 may have an elastic modulus of about 7 MPa to about 30 MPa, or about 5 MPa to about 25 MPa, or about 10 MPa to about 20 MPa. By having the modulus within the above range, the second buffer layer 15 may effectively absorb and/or smooth an external impact. In an exemplary embodiment, the second buffer layer 15 may have an elastic modulus of, for example, about 10 MPa to 20 MPa.

The second buffer layer 15 may include a polymer resin satisfying the modulus, for example, polyurethane, poly(meth)acrylate, a silicone resin, or a combination thereof satisfying the modulus, but is not limited thereto.

The second buffer layer 15 may have a uniform thickness through a whole surface, for example, a thickness of about 10 µm to about 250 µm, or about 15 to about 200 µm, or about 25 to about 200 µm. The second buffer layer 15 has a uniform thickness throughout the entire second buffer layer, so the window 10 may be folded, bent or rolled regardless of the direction and/or the position in which the folding, bending, or rolling occurs. In addition, as the second buffer layer 15 has the thickness within the range, the window 10 may be effectively folded, bent and/or rolled while effectively absorbing and/or smoothing any external impact.

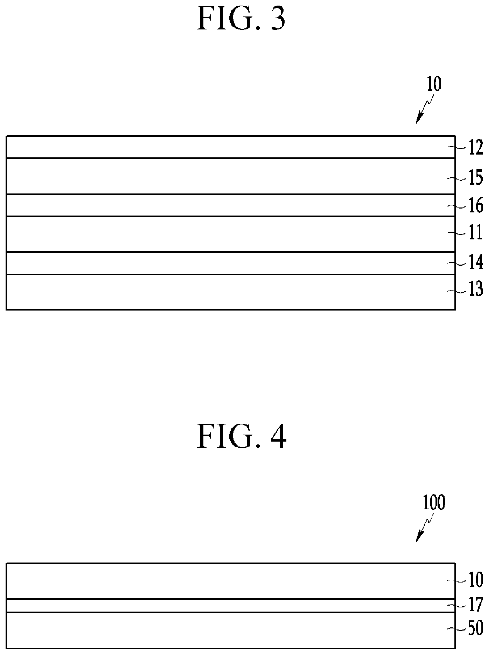

FIG. 3 is a cross-sectional view of a window for a display device, according to another embodiment.

As shown in FIG. 3, the window 10 for a display device according to the present embodiment includes a substrate 11, a protective layer 12 disposed on the substrate 11, a first buffer layer 13 under the substrate 11, a first transparent adhesion layer 14 disposed between the substrate 11 and the first buffer layer 13 and binding them together, and a second buffer layer 15 disposed on the substrate 11, alike the embodiment illustrated in FIG. 2.

However, the window 10 for a display device according to the present embodiment further includes a second transparent adhesion layer 16 disposed between the substrate 11 and the second buffer layer 15, which differs from the embodiment in FIG. 2.

The second transparent adhesion layer 16 may bind the substrate 11 and the second buffer layer 15 together. The second transparent adhesion layer 16 may include an adhesive, for example, an optically clear adhesive (OCA).

The second transparent adhesion layer 16 may secondarily absorb and/or smooth an impact which is transmitted toward the upper surface of the substrate 11 and the lower surface of the substrate 11, in addition to binding the substrate 11 with the second buffer layer 15. Thereby, the second transparent adhesion layer 16 may effectively absorb and/or smooth an impact transmitted toward the upper surface of the substrate 11 and/or the lower surface of the substrate 11, together with the second buffer layer 15.

The second transparent adhesion layer 16 may have, for example, a modulus of less than or equal to about 0.1 MPa, or less than or equal to about 0.05 MPa, or less than or equal to about 0.01 MPa. Within the range, it may have a modulus of, for example, about 0.001 MPa to about 0.1 MPa, or about 0.005 MPa to about 0.1 MPa, or for example, a modulus of about 0.01 MPa to about 0.1 MPa.

The second transparent adhesion layer 16 may have, for example, a thickness of about 5 µm to about 200 µm. Within the range, it may have a thickness of, for example, about 5 µm to about 150 µm, a thickness of about 10 µm to about 120 µm, and a thickness of about 15 µm to about 100 µm.

The window 10 for a display device may be applied to various types of display devices.

The window 10 for a display device may be attached on the display panel. In this case, the display panel and the window 10 for a display device may be directly bound to one another or may be bound together by interposing an adhesive therebetween.

The window 10 for a display device in FIGS. 2 and 3 may be bent, folded, or rolled in a variety of shapes, and is bendable, foldable, or rollable at any points of the window 10, similarly to the window 10 shown in FIGS. 6 to 10.

FIG. 4 is a cross-sectional view of a display device 100 according to an embodiment.

As shown in FIG. 4, the display device 100 according to one embodiment includes a display panel 50, a window 10, and a third transparent adhesion layer 17.

The display panel 50 may be, for example, an organic light emitting display panel or a liquid crystal display panel, for example, a bendable display panel, a foldable display panel, or a rollable display panel.

The window 10 may be disposed on the side facing an observer, and the structure thereof is the same as described above.

The display panel 50 and the window 10 are bound together by a third transparent adhesion layer 17. The third transparent adhesion layer 17 may include an adhesive, for example, an optically clear adhesive (OCA).

The third transparent adhesion layer 17 may have, for example a modulus of less than or equal to about 0.1 MPa, or less than or equal to about 0.05 MPA, or less than or equal to about 0.01 MPa. It may have, for example, a modulus of about 0.001 MPa to about 0.1 MPa within the range, for example, or about 0.005 MPa to about 0.1 MPa, or a modulus of about 0.01 MPa to about 0.1 MPa.

The third transparent adhesion layer 17 may have, for example a thickness of about 5 µm to about 200 µm. It may have a thickness of, for example, about 5 µm to about 150 µm, a thickness of about 10 µm to about 120 µm, and a thickness of about 15 µm to about 100 µm.

The third transparent adhesion layer 17 secondarily absorbs and/or smooths any impact force which may be transmitted toward the display panel 50 side of the display device, in addition to playing a role in binding the display panel 50 with the window 10. Thereby, the third transparent adhesion layer 17 may effectively absorb and/or smooth an impact force transmitted toward the display panel 50 side of the display device together with the first buffer layer 13 and the first transparent adhesion layer 14 of the window 10.

Another layer may be further interposed between the display panel 50 and the window 10. For example, a single polymer layer or a plurality of polymer layers (not shown) and optionally a transparent adhesion layer (not shown) may be further included.

FIG. 5 is a cross-sectional view of a display device 100 according to another embodiment.

Referring to FIG. 5, the display device 100 according to the present embodiment includes a display panel 50, a window 10, a third transparent adhesion layer 17, and a touch panel 70 disposed between the display panel 50 and the window 10.

The display panel 50 may be, for example, an organic light emitting display panel or a liquid crystal display panel, for example, a bendable display panel, a foldable display panel, or a rollable display panel.

The window 10 may be disposed on an observer side, and the structure is the same as described above.

The touch panel 70 may be disposed adjacent to each of the window 10 and the display panel 50. The touch panel 70 is positioned so as to recognize the touched position and the position change when the window is touched by a human hand, or by another material, and then to output a touch signal. The driving module (not shown) may monitor a position where touch panel is touched based upon the output touch signal; recognize an icon marked at the touched position; and control the device response to carry out a function corresponding to the recognized icon, and as a result, the function performance results are expressed on the display panel 50.

Another layer may be interposed between the touch panel 70 and the window 10, for example, a single polymer layer or a plurality polymer layers (not shown), and optionally a transparent adhesion layer (not shown) may be further included.

The display device may be applied to a variety of electronic devices such as a smart phone, a tablet PC, a camera, a touch screen device, and so on, but is not limited thereto.

Hereinafter, the present disclosure is illustrated in more detail with reference to examples. However, these examples are exemplary, and the present disclosure is not limited thereto.

### Examples

### Manufacture of Window

### Preparation Example 1

A colorless polyimide (CPI) film (TS-50-P, Kolon) having a thickness of 50 µm and a thermoplastic polyurethane film (TPU) (elastic modulus: about 15 MPa) having a thickness of 150 µm are assembled by interposing an optically clear adhesive (OCA) (8147, 3M) (elastic modulus: less than or equal to 0.1 MPa) having a thickness of 50 µm, using a roll-to-roll method. Subsequently, a composition for a protective layer (an organic-inorganic hybrid composition including a mixture of 15 wt% of (3-mercaptopropyl)trimethoxysilane (MPTMS)-modified silica, an inorganic binder (NCH2020, Miwon Specialty Chemical Co., Ltd.), and urethane acrylate organic binder (MU9800, Miwon Specialty Chemical Co., Ltd.)) is coated by a doctor blade on the opposite surface of the colorless polyimide film and dried, then photocured in a light intensity of 33 milliwatt per square centimeter (mW/cm²) for 30 seconds to provide a protective layer (HC) having a thickness of 10 µm, and to provide a window.

In the window, TPU (150 µm)/OCA (50 µm)/CPI (50 µm)/HC (10 µm) are sequentially laminated from the lower part.

### Preparation Example 2

A window is obtained in accordance with the same procedure as in Preparation Example 1, except that an optically clear adhesive having a thickness of 25 µm is used instead of the optically clear adhesive having a thickness of 50 µm.

In the window, TPU (150 µm)/OCA (25 µm)/CPI (50 µm)/HC (10 µm) are sequentially laminated from the lower part.

### Comparative Preparation Example 1

A composition for a protective layer is coated by a doctor blade on a colorless polyimide film having a thickness of 50 µm and dried and then photocured in a light intensity of 33 mW/cm² for 30 seconds to provide a protective layer having a thickness of 10 µm, to provide a window.

In the window, CPI (50 µm)/HC (10 µm) are sequentially laminated from the lower part.

### Comparative Preparation Example 2

A window is prepared in accordance with the same procedure as in Preparation Example 1, except that no optically clear adhesive is used.

In the window, TPU (150 µm)/CPI (50 µm)/HC (10 µm) are sequentially laminated from the lower part.

### Comparative Preparation Example 3

A window is obtained in accordance with the same procedure as in Preparation Example 1, except that a polyacryl film (PA) (ISR-ACF-JPS-T, Iwatani) (elastic modulus: 0.7 MPa) having a thickness of 50 µm is used instead of the thermoplastic polyurethane film.

In the window, PA (50 µm)/OCA (50 µm)/CPI (50 µm)/HC (10 µm) are sequentially laminated from the lower part.

### Comparative Preparation Example 4

A composition for a protective layer (organic/inorganic hybrid urethane acrylate) is coated by a doctor blade on a colorless polyimide film having a thickness of 50 µm and dried and then photocured in a light intensity of 33 mW/cm² for 30 seconds to provide a protective layer (HC) having a thickness of 10 µm. Subsequently, the colorless polyimide film coated with the protective layer and a thermoplastic polyurethane film (elastic modulus: about 15 MPa) having a thickness of 150 µm are assembled by interposing an optically clear adhesive having a thickness of 25 µm (OCA) (8147, 3M) (elastic modulus: less than or equal to 0.1 MPa) using a roll-to-roll method. Subsequently, a composition for a protective layer (organic/inorganic hybrid urethane acrylate) is coated by a doctor blade on the thermoplastic polyurethane and dried and then photocured in a light intensity of 33 mW/cm² for 30 seconds to provide a protective layer having a thickness of 30 µm, so a window is obtained.

CPI (50 µm)/HC (10 µm)/OCA (25 µm)/TPU (150 µm)/HC (30 µm) are sequentially laminated from the lower part in the window.

### Manufacture of Display Device

### Example 1

A display panel (Samsung Electronics Co., Ltd., S6 Galaxy panel) and the window obtained from Preparation Example 1 are assembled using an optically clear adhesive (8147, 3M) (elastic modulus: less than or equal to 0.1 MPa) to provide a sample.

### Example 2

A display panel (Samsung Electronics Co., Ltd., S6 Galaxy panel) and the window obtained from Preparation Example 2 are assembled using an optically clear adhesive (8147, 3M) (elastic modulus: less than or equal to 0.1 MPa) to provide a sample.

### Comparative Example 1

A display panel (Samsung Electronics Co., Ltd., S6 Galaxy panel) and the window obtained from Comparative Preparation Example 1 are assembled using an optically clear adhesive (8147, 3M) (elastic modulus: less than or equal to 0.1 MPa) to provide a sample.

### Comparative Example 2

A display panel (Samsung Electronics Co., Ltd., S6 Galaxy panel) and the window obtained from Comparative Preparation Example 2 are assembled using an optically clear adhesive (8147, 3M) (elastic modulus: less than or equal to 0.1 MPa) to provide a sample.

### Comparative Example 3

A display panel (Samsung Electronics Co., Ltd., S6 Galaxy panel) and the window obtained from Comparative Preparation Example 3 are assembled using an optically clear adhesive (8147, 3M) (elastic modulus: less than or equal to 0.1 MPa) to provide a sample.

### Comparative Example 4

A display panel (Samsung Electronics Co., Ltd., S6 Galaxy panel) and the window obtained from Comparative Preparation Example 4 are assembled by an optically clear adhesive (8147, 3M) (elastic modulus: less than or equal to 0.1 MPa) to provide a sample.

### Evaluation

### Evaluation 1

Samples obtained from Examples 1 and 2 and Comparative Examples 1 to 4 are measured for a surface hardness, an impact resistance, and a stiffness.

The surface hardness is evaluated by measuring a pencil scratch hardness using a pencil hardness meter (an automatic pencil scratch hardness tester No. 553-M1, YASUDA SEIKI SEISAKUSHO Ltd.) and a Mitsubishi pencil of varying hardness, according to ASTM D3363. Specifically, when a pencil is moved back and forth in a distance of 10 mm for 5 times at a speed of 60 mm/min under a vertical load of 1 kg on the upper surface of the window, the maximum pencil hardness, at which no discernable defects are measured, is designated as the pencil hardness.

The impact resistance of the display device is assessed using a Dupont Impact Tester. A pendulum having a predetermined weight (e.g., 30 grams) is dropped from a predetermined height (e.g., about 0.5 cm to about 100 cm) onto the window of the display device. The impact resistance is determined as a highest (i.e., maximum) height from which the pendulum is dropped and which does not generate a bright spot on the display panel. The bright spot is generated due to damage of the display panel. As the height at which the bright spot is not generated increases, the window has the stronger impact resistance.

The stiffness is determined as a bending load by a force applied when the window is folded at a desirable curvature radius.

Whether the terminal ends of the window are delaminated or curled (or not) is visually monitored by an observer.

The results of the tests are shown in Table 1:

**Table 1**

| | Surface hardness | Generation height of bright spot | Stiffness (N) | Curl generation* |
|---|---|---|---|---|
| Example 1 | 4H | 12 cm | 7.1 | X |
| Example 2 | 4H | 10 cm | 7.0 | X |
| Comparative Example 1 | 4H | 1 cm | 6.3 | O (≥ 20 mm) |
| Comparative Example 2 | 4H | 5 cm | 6.8 | X |
| Comparative Example 3 | 4H | 6 cm | 6.6 | X |
| Comparative Example 4 | 4H | 4 cm | 9.5 | X |

| | | | | |
|---|---|---|---|---|
| *X, no curl was observed; O, curl was observed. | | | | |

Referring to Table 1, it is confirmed that the display devices including the windows of Examples 1, 2 demonstrate improved impact resistance as compared to the display devices including the windows from Comparative Examples 1 to 4.

### Evaluation 2

Samples obtained from Examples 1 and 2 are evaluated for flexibility.

The flexibility is evaluated by dynamic and static folding tests.

The dynamic folding test is carried out by repeating a movement of folding/unfolding the window samples according to Examples 1 and 2, disposed between two stainless steel plates, at a curvature radius (r) of 1 mm and unfolding the same for 200,000 times and inspecting the appearance of the folded region.

The static folding test is carried out by fixing the window sample at a curvature radius (r) of 1 mm between the same two stainless steel plates as above, allowing the window sample to stand at a room temperature for 240 hours, and then unfolding the window sample to monitor whether cracks and/or wrinkles are found at the folded region.

The results are shown in Table 2.

**Table 2**

| | | Example 1 | Example2 |
|---|---|---|---|
| Dynamic folding | 200,000 times @ 1R | *appearance quality good | appearance quality good |
| Static folding | 240 hr @ 1 R | appearance quality good | appearance quality good |

Referring to Table 2, no cracks or wrinkles are observed in the window sample, and thus an appearance deformation is not found in the samples obtained from Examples 1 and 2. The results thus confirm that the window disclose herein may be effectively applied to a foldable, bendable and/or rollable display device.

While this disclosure has been described in connection with what is presently considered to be practical example embodiments, it is to be understood that the invention is not limited to the disclosed embodiments, but, on the contrary, is intended to cover various modifications and equivalent arrangements included within the scope of the appended claims.

## Claims

1. A window for a display device, comprising:
a polymer substrate,
a first buffer layer under the polymer substrate and comprising polyurethane, a silicone resin, or a combination thereof,
a first transparent adhesion layer between the polymer substrate and the first buffer layer, and
a protective layer on the polymer substrate.

2. The window for a display device of claim 1, wherein the first buffer layer has a thickness of 150 micrometers to 250 micrometers.

3. The window for a display device of claims 1 or 2, wherein the first buffer layer has a substantially uniform thickness throughout the buffer layer.

4. The window for a display device of any of claims 1-3, wherein the polymer substrate comprises polyimide, polyamide, polyethylene terephthalate, polyethylene naphthalate, polymethylmethacrylate, polycarbonate, a copolymer thereof, or a combination thereof;
preferably wherein the polymer substrate has a thickness of 25 micrometers to 100 micrometers.

5. The window for a display device of any of claims 1-4, wherein the protective layer comprises a (meth)acryl resin, an epoxy resin, a silicone resin, an oxetane resin, a urethane resin, a urethane (meth)acrylate resin, an inorganic particle, polysilsesquioxane, or a combination thereof.

6. The window for a display device of any of claims 1-5, wherein the protective layer has a thickness of 1 micrometer to 50 micrometers.

7. The window for a display device of any of claims 1-6, wherein the window for a display device further comprises a second buffer layer between the polymer substrate and the protective layer.

8. The window for a display device of claim 7, wherein the window for a display device further comprises a second transparent adhesion layer between the polymer substrate and the second buffer layer.

9. A display device comprising
a display panel, and
the window for a display device of any of claims 1-8.

10. The display device of claim 9, wherein the display panel is an organic light emitting display panel or a liquid crystal display panel; and/or
wherein the display panel is a bendable display panel, a foldable display panel, or a rollable display panel; and/or
wherein the display device further comprises a touch panel between the display panel and the window for the display device.

## Patentansprüche

1. Fenster für eine Anzeigevorrichtung, umfassend: ein Polymersubstrat,
eine erste Pufferschicht unter dem Polymersubstrat und umfassend ein Polyurethan, ein Siliziumharz oder eine Kombination daraus,
eine erste transparente Adhäsionsschicht zwischen dem Polymersubstrat und der ersten Pufferschicht, und
eine Schutzschicht auf dem Polymersubstrat.

2. Fenster für eine Anzeigevorrichtung nach Anspruch 1, wobei die erste Pufferschicht eine Dicke von 150 Mikrometer bis 250 Mikrometer aufweist.

3. Fenster für eine Anzeigevorrichtung nach Anspruch 1 oder 2, wobei die erste Pufferschicht über die gesamte Pufferschicht eine im Wesentlichen gleichförmige Dicke aufweist.

4. Fenster für eine Anzeigevorrichtung nach einem der Ansprüche 1 bis 3, wobei das Poylmersubstrat Polyimid, Polyamid, Polyethylenterephthalat, Polyethylennaphthalat, Polymethylmethacrylat, Polycarbonat, ein Copolymer davon oder eine Kombination daraus umfasst;
vorzugsweise wobei des Polymersubstrat eine Dicke von 25 Mikrometer bis 100 Mikrometer aufweist.

5. Fenster für eine Anzeigevorrichtung nach einem der Ansprüche 1 bis 4, wobei die Schutzschicht (Meth)Acrylharz, ein Epoxidharz, ein Siliziumharz, ein Oxetanharz, ein Urethanharz, ein Urethan(meth)acrylatharz, einen anorganischen Partikel, Polysilsesquioxan oder eine Kombination daraus umfasst.

6. Fenster für eine Anzeigevorrichtung nach einem der Ansprüche 1 bis 5, wobei die Schutzschicht eine Dicke von 1 Mikrometer bis 50 Mikrometer aufweist.

7. Fenster für eine Anzeigevorrichtung nach einem der Ansprüche 1 bis 6, wobei das Fenster für eine Anzeigevorrichtung ferner eine zweite Pufferschicht zwischen dem Polymersubstrat und der Schutzschicht umfasst.

8. Fenster für eine Anzeigevorrichtung nach Anspruch 7, wobei das Fenster für eine Anzeigevorrichtung ferner eine zweite transparente Adhäsionsschicht zwischen dem Polymersubstrat und der zweiten Schutzschicht umfasst.

9. Anzeigevorrichtung, umfassend ein Anzeigefeld, und
das Fenster für eine Anzeigevorrichtung nach einem der Ansprüche 1 bis 8.

10. Anzeigevorrichtung nach Anspruch 9, wobei das Anzeigefeld ein organisches lichtemittierendes Anzeigefeld oder ein Flüssigkristallanzeigefeld ist; und/oder
wobei das Anzeigefeld ein biegbares Anzeigefeld, ein faltbares Anzeigefeld oder ein rollbares Anzeigefeld umfasst; und/oder
wobei die Anzeigevorrichtung ferner ein Berührungsfeld zwischen dem Anzeigefeld und dem Fenster für die Anzeigevorrichtung umfasst.

## Revendications

1. Fenêtre pour un dispositif d'affichage, comprenant :
un substrat de polymère,
une première couche tampon sous le substrat polymère, et comprenant du polyuréthane, une résine de silicone, ou une combinaison de ces derniers,
une première couche d'adhérence transparente entre le substrat polymère et la première couche tampon, et
une couche de protection sur le substrat polymère.

2. Fenêtre pour un dispositif d'affichage selon la revendication 1, la première couche tampon mesurant de 150 micromètres à 250 micromètres d'épaisseur.

3. Fenêtre pour un dispositif d'affichage selon les revendications 1 ou 2, l'épaisseur de la première couche tampon étant substantiellement uniforme d'un bout à l'autre de la couche tampon.

4. Fenêtre pour un dispositif d'affichage selon une quelconque des revendications 1 à 3, le substrat polymère comprenant du poly-imide, du polyamide, du polyéthylène térephtalate, du polyéthylène naphtalate, du polyméthacrylate de méthyle, du polycarbonate, un copolymère de ces derniers, ou une combinaison de ces derniers ;
le substrat polymère mesurant de préférence de 25 micromètres à 100 micromètres d'épaisseur.

5. Fenêtre pour un dispositif d'affichage selon une quelconque des revendications 1 à 4, la couche de protection comprenant une résine méthacrylique, une résine époxy, une résine de silicone, une résine d'oxétane, une résine d'uréthane, une résine de méthacrylate d'uréthane, une particule inorganique, du polysilsesquioxane, ou une combinaison de ces derniers.

6. Fenêtre pour un dispositif d'affichage selon une quelconque des revendications 1 à 5, la couche de protection mesurant de 1 micromètre à 50 micromètres d'épaisseur.

7. Fenêtre pour un dispositif d'affichage selon une quelconque des revendications 1 à 6, la fenêtre pour un dispositif d'affichage comprenant en outre une deuxième couche tampon entre le substrat polymère et la couche de protection.

8. Fenêtre pour un dispositif d'affichage selon la revendication 7, la fenêtre pour un dispositif d'affichage comprenant en outre une deuxième couche d'adhérence transparente entre le substrat polymère et la deuxième couche tampon.

9. Dispositif d'affichage comprenant un panneau d'affichage, et la fenêtre pour un dispositif d'affichage selon une quelconque des revendications 1 à 8.

10. Dispositif d'affichage selon la revendication 9, le panneau d'affichage étant un panneau d'affichage électroluminescent organique ou un panneau d'affichage à cristaux liquides ; et/ou
le panneau d'affichage étant un panneau d'affichage cintrable, un panneau d'affichage pliable, ou un panneau d'affichage roulant ; et/ou
le dispositif d'affichage comprenant en outre un panneau tactile entre le panneau d'affichage et la fenêtre pour le dispositif d'affichage.
